# FASCICULE DE BREVET EUROPEEN

(11) **EP 1 354 357 B1**
(45) Date de publication et mention de la délivrance du brevet: **25.05.2005**
(21) Numéro de dépôt: 01989657.0
(22) Date de dépôt: 21.12.2001
(51) Int. Cl.: H01L 23/522

(54) **DISPOSITIF SEMI-CONDUCTEUR A LIGNE DE TRANSMISSION PERFECTIONNEE**
HALBLEITERBAUELEMENT MIT VERBESSERTER ÜBERTRAGUNGSLEITUNG
SEMICONDUCTOR DEVICE WITH AN IMPROVED TRANSMISSION LINE

(30) Priorité: 22.01.2001 FR 0100819
(43) Date de publication de la demande: 22.10.2003
(73) Titulaire: STMicroelectronics S.A., 92120 Montrouge (FR)
(72) Inventeur: CARPENTIER, Jean-François, F-38100 Grenoble (FR)
(74) Mandataire: Casalonga, Axel
(86) Numéro de dépôt international: PCT/FR2001/004142
(87) Numéro de publication internationale: WO 2002/058146

(56) Documents cités:
- EP-A- 0 661 744
- US-A- 5 136 358
- US-A- 6 133 621
- PATENT ABSTRACTS OF JAPAN vol. 1998, no. 10, 31 août 1998 (1998-08-31) -& JP 10 125779 A (TOSHIBA CORP), 15 mai 1998 (1998-05-15)

## Description

La présente invention concerne un dispositif semi-conducteur à circuits intégrés comprenant des couches superposées prévues à des niveaux différents sur un substrat et a pour but la réalisation d'au moins une ligne de transmission dans de tels circuits intégrés.

Conventionnellement, les lignes de transmission qui sont parcourues par un courant électrique, dans le but d'interconnecter des composants des circuits intégrés ou dans le but de réaliser des circuits radio-fréquences intégrés sont formées par des micro-rubans métalliques, qui peuvent être ou sont généralement situés dans le voisinage d'un plan de masse, à faible distance du substrat constitué généralement par du silicium.

Compte tenu des faibles sections et plus particulièrement des faibles épaisseurs desdits micro-rubans métalliques, de telles lignes de transmission conventionnelles présentent des pertes électriques élevées. De plus, compte tenu de la faible distance entre les micro-rubans et les plans de masse, l'inductance par l'unité de longueur de ces micro-rubans est faible et la capacité résultante par unité de longueur est élevée, de telle sorte que cela conduit à une impédance caractéristique d'ensemble faible.

Le document EP 661 744 A1 décrit des lignes de protection situées sur plusieurs niveaux au-dessus d'un circuit intégré, d'une coté et de l'autre d'une ligne de transmission, incluant des lignes et des plans de masse.

La présente invention a pour but la réalisation dans un dispositif semi-conducteur à circuits intégrés d'au moins une ligne de transmission à faible perte et à impédance caractéristique élevée.

Le dispositif semi-conducteur à circuits intégrés qui comprend des couches superposées prévues à des niveaux différents sur un substrat, comprend, selon la revendication 1 de l'invention, un ruban métallique formé dans une couche de référence et traversé par un courant électrique, un plan de masse métallique formé dans une couche située à un niveau inférieur à la couche de référence et présentant une fente qui s'étend en dessous dudit ruban en le longeant, un écran électrostatique formé dans une couche située à un niveau inférieur au plan de masse et comprenant une multiplicité de bandes espacées, en un matériau conducteur de l'électricité, qui s'étendent en travers de ladite fente, et des jonctions conductrices permettant de relier électriquement les extrémités de chaque bande aux parties du plan de masse situées de part et d'autre de sa fente.

Selon une variante de l'invention, ledit ruban métallique constitue une ligne d'inter-connexion entre deux composants intégrés.

Selon une autre variante de l'invention, ledit ruban métallique constitue une inductance.

Selon l'invention, lesdites bandes conductrices s'étendent de préférence transversalement à la direction dudit ruban métallique.

Selon l'invention, les bords opposés de ladite fente s'étendent de préférence parallèlement aux bords opposés dudit ruban métallique.

Selon l'invention, les parties d'extrémité desdites bandes conductrices s'étendent en dessous dudit plan de masse métallique, ledites jonctions conductrices s'étendant perpendiculairement à ce plan.

Selon l'invention, ledit écran électrostatique peut être intégré dans la surface du substrat.

Selon l'invention, la largeur desdites bandes conductrices est de préférence égale à la largeur dudit ruban métallique.

Selon l'invention, ledit ruban métallique est de préférence centré par rapport à la direction de ladite fente et sa largeur est au plus égale à la largeur de cette fente.

Selon l'invention, la distance entre ledites bandes conductrices est de préférence inférieure à leur largeur.

Selon l'invention, la largeur de ladite fente est de préférence comprise entre une et trois fois la largeur dudit ruban métallique.

La présente invention sera mieux comprise à l'étude de dispositifs semi-conducteurs à circuit intégré comprenant des lignes de transmission, décrits à titre d'exemples non limitatifs et illustrés par le dessin sur lequel :
- la figure 1 représente une vue en perspective d'une ligne de transmission intégrée dans un dispositif semi-conducteur selon la présente invention ;
- la figure 2 représente une coupe transversale de la ligne de transmission de la figure 1 ;
- la figure 3 représente une vue latérale d'une première application de la ligne de transmission précitée dans un dispositif semi-conducteur ;
- et la figure 4 représente une vue de dessus d'une seconde application de la ligne de transmission précitée dans un dispositif semi-conducteur.

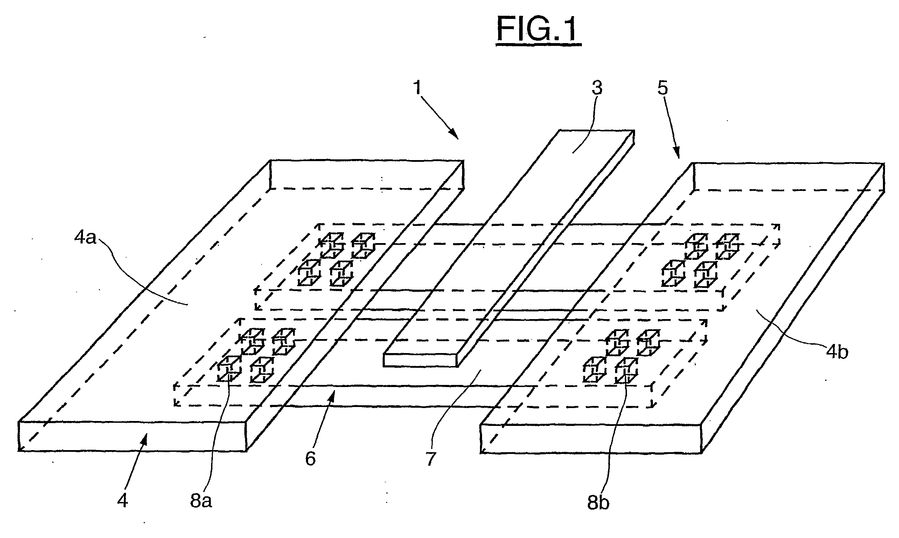

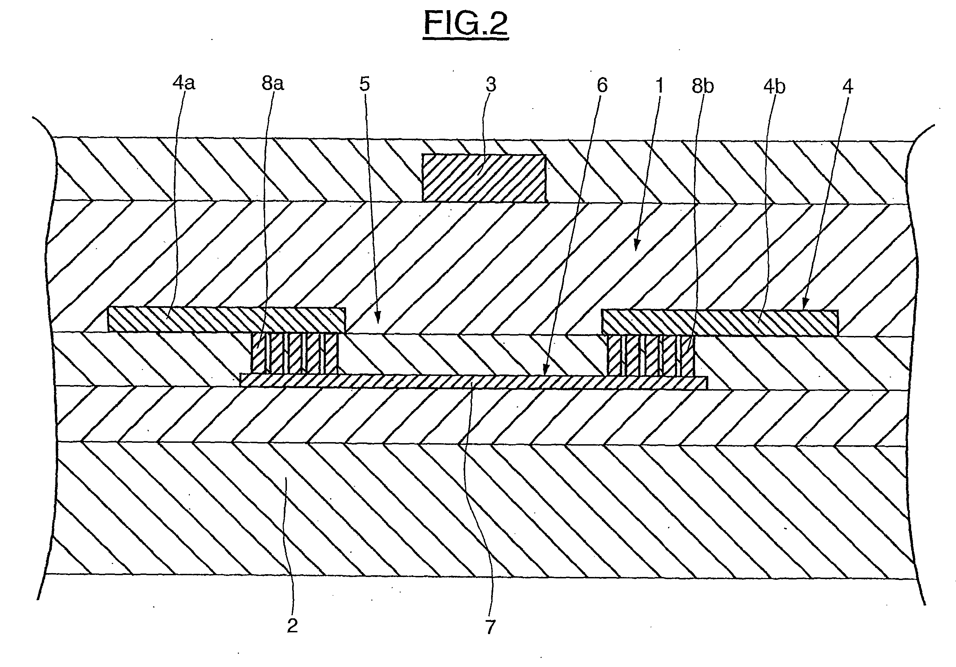

En se reportant aux figures 1 et 2, on voit qu'on a représenté un dispositif semi-conducteur 1 à plusieurs couches superposées prévues à des niveaux différents sur un substrat 2.

Le dispositif semi-conducteur 1 comprend, dans une couche située à un niveau dit de référence, un ruban métallique longitudinal 3, de section rectangulaire, susceptible d'être traversé par un courant électrique.

Dans une couche située à un niveau inférieur de celui du ruban métallique 3 transporteur de courant, le dispositif semi-conducteur 1 comprend un plan de masse 4 qui comprend deux rubans métalliques longitudinaux de masse 4a et 4b distants l'un de l'autre de manière à former une fente longitudinale 5 qui s'étend en-dessous du ruban métallique 3. Les bords longitudinaux des rubans de masse 4a et 4b sont parallèles et s'étendent parallèlement au ruban métallique 3, le ruban 3 étant centré par rapport à la fente 5.

De préférence, la largeur du ruban métallique 3 transporteur de courant est au plus égale à la largeur de la fente 5 entre les rubans de masse 4a et 4b.

Dans une couche située à un niveau inférieur à celui du plan de masse 4, le dispositif semi-conducteur 1 comprend un écran électro-statique 6 qui est constitué par une multiplicité de bandes 7 qui s'étendent en travers de la fente 5 et qui sont espacées dans le sens longitudinal. Ces bandes 7 sont en un matériau conducteur de l'électricité, par exemple en polysilicium silicuré et sont de section rectangulaire

Les parties d'extrémité des bandes conductrices 7 s'étendent en-dessous des bandes métalliques 4a et 4b du plan de masse 4 et sont reliées à ces dernières grâce à des jonctions verticales 8a et 9a conductrices de l'électricité qui constituent des vias par exemple en tungsten.

De préférence, la largeur des bandes conductrices 7 constituant l'écran électro-statique 6 est de préférence égale à la largeur du ruban métallique 3 et l'espace séparant ces bandes conductrices 7 est de préférence inférieur à leur largeur et choisi de préférence au minimum permis par la technologie de fabrication employée.

Dans un exemple concret de réalisation, la distance verticale entre le ruban métallique 3 transporteur de courant et le plan de masse 4 est approximativement égale à quatre microns, la distance entre le plan de masse 4 et l'écran électro-statique 6 est approximativement égale à deux microns et la distance entre l'écran métallique 6 et la surface du substrat 2 est approximativement égale à 0,4 micron. Dans une variante d'exécution, l'écran électro-statique 6 pourrait être accolé à la surface du substrat 2.

La largeur du ruban longitudinal 3 transporteur de courant étant approximativement égale à vingt microns, il est souhaitable que la largeur de la fente 5 soit comprise entre une et trois fois la largeur du ruban métallique 3.

Bien entendu, le ruban 3, le plan, de masse 4, l'écran 6 et les jonctions 8a et 8b sont réalisés dans des couches diélectriques.

La disposition qui vient d'être décrite présente les avantages suivants.

Grâce à la prévision de la fente 5 dans le plan de masse 4, qui éloigne ce dernier du ruban 3 transporteur de courant, il est possible d'augmenter la largeur de ce dernier tout en conservant une inductance par unité de longueur élevée et de bénéficier de la largeur des rubans de masse 4a et 4b du plan de masse 4 située latéralement pour véhiculer les retours de courant.

De plus, l'écran électrostatique 6 constitué par les bandes conductrices 7 permet de réduire les pertes en courant au sein du substrat 2 car il empêche le champ électrique créé par le ruban métallique 3 d'atteindre le substrat 2 et, pour le moins, limite son effet dans ce dernier de façon à ne pas perturber les autres composants du dispositif semi-conducteur 1.

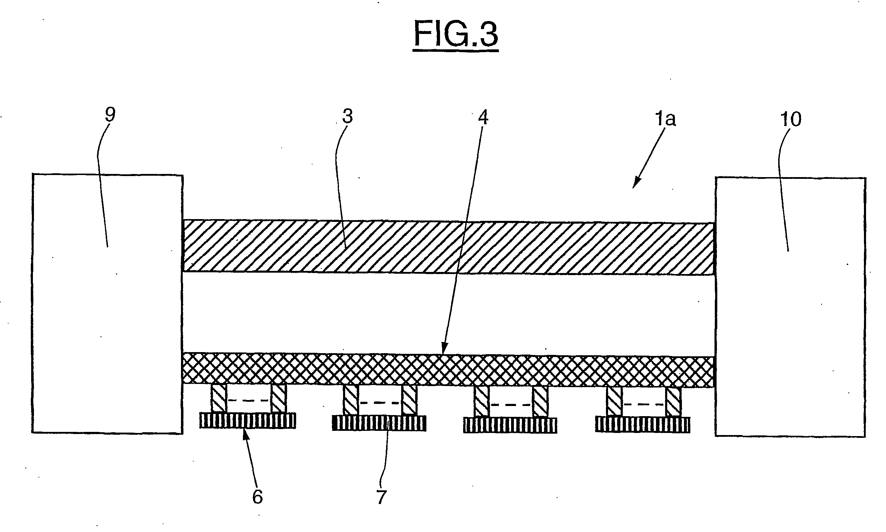

En se reportant à la figure 3, on voit qu'on a représenté un dispositif semi-conducteur la dans lequel le ruban métallique 3 constitue un moyen d'inter-connexion entre deux composants 9 et 10, par exemple deux éléments passifs, la fente 5 s'étendant approximativement sur toute la distance séparant ces composants 9 et 10 et les bandes conductrices transversales 7 de l'écran électro-statique 6 étant régulièrement espacées le long de cette dernière.

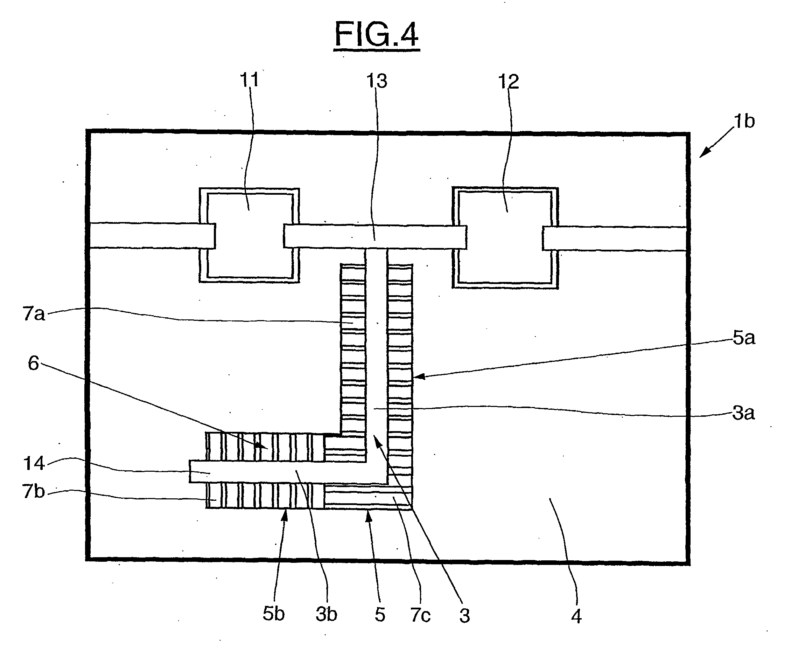

En se reportant à la figure 4, on voit qu'on a représenté un dispositif semi-conducteur 1b dans lequel le ruban métallique 3 constitue l'inductance d'un circuit LC.

Dans ce mode de réalisation, le dispositif semi-conducteur 1b comprend deux capacités 11 et 12 reliées électriquement par un ruban métallique rectiligne 13 qui s'étend au même niveau que le ruban métallique 3.

Le ruban métallique 3 transporteur de courant s'étend en formant un L qui présente une branche 3a qui s'étend perpendiculairement au ruban rectiligne 13 et dont l'extrémité est reliée sensiblement au milieu de ce dernier, ainsi qu'une branche 3b qui s'étend perpendiculairement à sa branche 3a et dont l'extrémité libre est reliée au plan de masse 4 par une jonction verticale 14.

La fente 5 prévue dans le plan de masse 4 s'étend également en formant un L dont les branches 5a et 5b longent à distance les branches 3a et 3b du ruban 3, comme décrit précédemment.

L'écran électrostatique 6 comprend des bandes conductrices 7a qui s'étendent transversalement à la branche 5a de la fente 5 et des bandes conductrices 7b qui s'étendent transversalement à la branche 5b de la fente 5. Dans la zone de la jonction entre les branches 5a et 5b de la fente 5, l'écran électro-statique 6 comprend des bandes 7c qui sont parallèles aux bandes conductrices 7a et dont une extrémité est reliée au plan de masse 4 comme décrit précédemment et leur autre extrémité est reliée à la première des bandes conductrices 7b.

La présente invention ne se limite pas aux exemples ci-dessus décrits. Bien des variantes de réalisation sont possibles sans sortir du cadre défini par les revendications.

## Revendications

1. Dispositif semi-conducteur à circuits intégrés comprenant des couches superposées prévues à des niveaux différents sur un substrat, **caractérisé par le fait qu'**il comprend :
- un ruban métallique (3) formé dans une couche de référence et traversé par un courant électrique,
- un plan de masse métallique (4) formé dans une couche située à un niveau inférieur à la couche de référence et présentant une fente (5) qui s'étend en dessous dudit ruban en le longeant,
- un écran électrostatique (6) formé dans une couche située à un niveau inférieur au plan de masse et comprenant une multiplicité de bandes espacées (7), en un matériau conducteur d'électricité, qui s'étendent transversalement à ladite fente,
- et des jonctions conductrices (8a, 8b) permettant de relier électriquement les extrémités de chaque bande aux parties du plan de masse situées de part et d'autre de sa fente.

2. Dispositif selon la revendication 1, **caractérisé par le fait que** ledit ruban métallique (3) constitue une ligne d'inter-connexion entre deux composants intégrés.

3. Dispositif selon l'une des revendications 1 et 2, **caractérisé par le fait que** ledit ruban métallique (3) constitue une inductance.

4. Dispositif selon l'une quelconque des revendications précédentes, **caractérisé par le fait que** lesdites bandes conductrices (7) s'étendent perpendiculairement à la direction dudit ruban métallique (3).

5. Dispositif selon l'une quelconque des revendications précédentes, **caractérisé par le fait que** les bords opposés de ladite fente s'étendent parallèlement aux bords opposés dudit ruban métallique.

6. Dispositif selon l'une quelconque des revendications précédentes, **caractérisé par le fait que** les parties d'extrémité desdites bandes conductrices (7) s'étendent en dessous dudit plan de masse métallique (4), ledites jonctions conductrices (8a, 8b) s'étendant perpendiculairement à ce plan.

7. Dispositif selon l'une quelconque des revendications précédentes, **caractérisé par le fait que** ledit écran électrostatique est intégré dans la surface du substrat.

8. Dispositif selon l'une quelconque des revendications précédentes, **caractérisé par le fait que** la largeur desdites bandes conductrices (7) est égale à la largeur dudit ruban métallique (3).

9. Dispositif selon l'une quelconque des revendications précédentes, **caractérisé par le fait que** ledit ruban métallique (3) est centré par rapport à la direction de ladite fente (5) et que sa largeur est au plus égale à la largeur de cette fente.

10. Dispositif selon l'une quelconque des revendications précédentes, **caractérisé par le fait que** la distance entre ledites bandes conductrices (7) est inférieure à leur largeur.

11. Dispositif selon l'une quelconque des revendications précédentes, **caractérisé par le fait que** la largeur de ladite fente (5) est comprise entre une et trois fois la largeur dudit ruban métallique (3).

## Patentansprüche

1. Halbleitervorrichtung mit integrierten Schaltungen, die übereinander liegende Schichten aufweist, die in verschiedenen Höhen auf einem Substrat vorgesehen sind, **dadurch gekennzeichnet, dass** sie:
- einen Metallstreifen (3), der in einer Bezugsschicht ausgebildet ist und von einem elektrischen Strom durchflossen wird,
- eine metallische Masseplatte (4), die in einer Schicht ausgebildet ist, die sich auf einer niedrigeren Höhe als die Bezugsschicht befindet und einen Schlitz (5) aufweist, der sich unter dem Streifen erstreckt, indem er an ihm entlang läuft,
- eine elektrostatische Abschirmung (6), die in einer Schicht ausgebildet ist, die sich auf einer niedrigeren Höhe als die Masseplatte befindet und mehrere in Abstand angeordnete Bänder (7) aus einem stromleitenden Material aufweist, die quer zum Schlitz verlaufen, und
- leitende Verbindungsstellen (8a, 8b), die es ermöglichen, die Enden jedes Bands elektrisch mit den Bereichen der Masseplatte zu verbinden, die sich zu beiden Seiten ihres Schlitzes befinden,
aufweist.

2. Vorrichtung nach Anspruch 1, **dadurch gekennzeichnet, dass** der Metallstreifen (3) eine Leiterbahn zwischen zwei integrierten Bauteilen bildet.

3. Vorrichtung nach einem der Ansprüche 1 und 2, **dadurch gekennzeichnet, dass** der Metallstreifen (3) eine Induktivität bildet.

4. Vorrichtung nach einem der vorhergehenden Ansprüche, **dadurch gekennzeichnet, dass** die leitenden Bänder (7) quer zur Richtung des Metallstreifens (3) verlaufen.

5. Vorrichtung nach einem der vorhergehenden Ansprüche, **dadurch gekennzeichnet, dass** die gegenüberliegenden Ränder des Schlitzes parallel zu den gegenüberliegenden Rändern des Metallstreifens verlaufen.

6. Vorrichtung nach einem der vorhergehenden Ansprüche, **dadurch gekennzeichnet, dass** die Endbereiche der leitenden Bänder (7) unter der metallischen Masseplatte (4) verlaufen, wobei die leitenden Verbindungsstellen (8a, 8b) senkrecht zu dieser Platte verlaufen.

7. Vorrichtung nach einem der vorhergehenden Ansprüche, **dadurch gekennzeichnet, dass** die elektrostatische Abschirmung in die Oberfläche des Substrats integriert ist.

8. Vorrichtung nach einem der vorhergehenden Ansprüche, **dadurch gekennzeichnet, dass** die Breite der leitenden Bänder (7) gleich der Breite des Metallstreifens (3) ist.

9. Vorrichtung nach einem der vorhergehenden Ansprüche, **dadurch gekennzeichnet, dass** der Metallstreifen (3) bezüglich der Richtung des Schlitzes (5) zentriert ist, und dass seine Breite höchstens gleich der Breite dieses Schlitzes ist.

10. Vorrichtung nach einem der vorhergehenden Ansprüche, **dadurch gekennzeichnet, dass** der Abstand zwischen den leitenden Bändern (7) geringer ist als ihre Breite.

11. Vorrichtung nach einem der vorhergehenden Ansprüche, **dadurch gekennzeichnet, dass** die Breite des Schlitzes (5) zwischen ein und dreimal so groß ist wie die Breite des Metallstreifens (3).

## Claims

1. Semiconductor device with integrated circuits comprising superimposed layers provided at different levels on a substrate, **characterized in that** it comprises:
- a metal strip (3) formed in a reference layer and through which an electric current passes,
- a metal earth plane (4) formed in a layer situated at a level lower than the reference layer and having a slit (5) which lies below said strip while running alongside it,
- an electrostatic shield (6) formed in a layer located at a level lower than the earth plane and comprising a multiplicity of spaced out bands (7), made of an electrically-conducting material, which extends perpendicularly to said slit, and
- conducting junctions (8a, 8b) making it possible to electrically connect the ends of each band to the parts of the earth plane situated on either side of its slit.

2. Device according to Claim 1, **characterized in that** said metal strip (3) constitutes a line for interconnecting two integrated components.

3. Device according to either of Claims 1 and 2, **characterized in that** said metal strip (3) constitutes an inductor.

4. Device according to any one of the preceding claims, **characterized in that** said conducting bands (7) lie perpendicularly to the direction of said metal strip (3).

5. Device according to any one of the preceding claims, **characterized in that** the opposed edges of said slit lie parallel to the opposed edges of said metal strip.

6. Device according to any one of the preceding claims, **characterized in that** the end parts of said conducting bands (7) lie below said metal earth plane (4), said conducting junctions (8a, 8b) lying perpendicularly to this plane.

7. Device according to any one of the preceding claims, **characterized in that** said electrostatic shield is integrated into the surface of the substrate.

8. Device according to any one of the preceding claims, **characterized in that** the width of said conducting bands (7) is equal to the width of said metal strip (3).

9. Device according to any one of the preceding claims, **characterized in that** said metal strip (3) is centred with respect to the direction of said slit (5) and **in that** its width is at the most equal to the width of this slit.

10. Device according to any one of the preceding claims, **characterized in that** the distance between said conducting bands (7) is less than their width.

11. Device according to any one of the preceding claims, **characterized in that** the width of said slit (5) is between one and three times the width of said metal strip (3)
